# EUROPÄISCHE PATENTSCHRIFT

(11) **EP 1 439 746 B1**
(45) Veröffentlichungstag und Bekanntmachung des Hinweises auf die Patenterteilung: **02.04.2008**
(21) Anmeldenummer: 03104743.4
(22) Anmeldetag: 17.12.2003
(51) Int. Cl.: H05K 7/14, H05K 5/02

(54) **Gehäuse für die Aufnahme eines Schaltungsträgers und Verfahren zur Herstellung eines Schaltungsmoduls**
Housing for circuit carrier and method of manufacturing a circuit module
Boîtier pour abriter un circuit et procédé de fabrication d'un module avec un circuit

(30) Priorität: 20.01.2003 DE 10301965
(43) Veröffentlichungstag der Anmeldung: 21.07.2004
(73) Patentinhaber: VDO Automotive AG, 93055 Regensburg (DE)
(72) Erfinder: Fischer, Georg, 93186, Reifenthal (DE); Schels, Florian, 92358, Schnufenhofen (DE); Smirra, Karl, 83512, Wasserburg (DE); Smit, Arnoud, 93059, Regensburg (DE); Ulm, Michael, 93087, Altegolfsheim (DE)

(56) Entgegenhaltungen:
- EP-A- 0 590 819
- DE-A1- 19 836 887
- DE-A1- 19 924 344
- DE-U1- 20 004 263
- US-A- 3 258 649
- US-A- 5 572 776
- US-A- 5 738 219

## Beschreibung

Die Erfindung betrifft ein Gehäuse für die Aufnahme eines Schaltungsträgers mit einem Gehäusegrundkörper, der ein Lager für den Schaltungsträger aufweist.

Die Erfindung betrifft ferner ein Verfahren zur Herstellung eines Schaltungsmoduls mit einem Gehäuse, in das ein Schaltungsträger eingebracht wird.

Derartige Gehäuse und derartige Verfahren sind allgemein bekannt. In der Automobilindustrie werden insbesondere Gehäuse benötigt, die einfach herstellbar sind und die in der Lage sind, in schmutz- und vibrationsbelasteten Umgebungen elektronische Komponenten öl- und spritzwasserdicht zu beherbergen. Derartige Gehäuse weisen einen Grundkörper auf, dessen Öffnungen durch Abdeckungen verschlossen werden. Im Inneren der Gehäuse sind Halterungen für Leiterplatten ausgebildet, von denen die Leiterplatten vibrationssicher gehalten werden. Üblicherweise werden die Leiterplatten in die Halterungen eingenietet, eingeschraubt oder auflaminiert. Hierzu muss die Halterung von beiden Seiten zugänglich sein. Um die Leiterplatten in den Halterungen zu befestigen, sind daher im Allgemeinen Öffnungen im Gehäuse vorzusehen, die nach der Montage der Leiterplatte abgedichtet werden müssen. Die herkömmlichen Gehäuse lassen sich daher nur umständlich montieren.

Aus der Druckschrift EP 0 991 308 A2 ist ein Gehäuse für die Aufnahme eines Schaltungsträgers mit einem Gehäusegrundkörper bekannt, der ein Lager und ein Gegenlager für den Schaltungsträger aufweist. Nach einer Verformung des Gehäusegrundkörpers, durch die der Abstand zwischen Lager und Gegenlager verringert wird, bilden Lager und Gegenlager eine den Schaltungsträger beidseitig fassende Halterung.

US 5,572,776 beschreibt eine Befestigung für die Aufnahme eines Schaltungsträgers mit einem Gehäusegrundkörper, der ein Lager und ein Gegenlager aufweist, die nach einer den Abstand zwischen Lager und Gegenlager verringernden Verformung des Gehäusegrundkörpers eine den Schaltungsträger beidseitig fassende Halterung bilden.

Ausgehend von diesem Stand der Technik liegt der Erfindung die Aufgabe zugrunde, ein Gehäuse zu schaffen, in dem Schaltungsträger auf einfache Weise vibrationssicher befestigt werden können. Der Erfindung liegt ferner die Aufgabe zugrunde, ein Verfahren zur Herstellung eines Schaltungsmoduls mit einem derartigen Gehäuse zu schaffen.

Diese Aufgaben werden durch ein Gehäuse und ein Verfahren mit den Merkmalen der unabhängigen Ansprüche gelöst. In davon abhängigen Ansprüchen sind vorteilhafte Ausgestaltungen und Weiterbildungen angegeben.

Bei dem auf einfache Weise montierbaren, vibrationssicheren Gehäuse ist der Grundkörper des Gehäuses aus einem Strangprofil hergestellt und in Form eines Hohlprofils ausgestaltet. Das Hohlprofil kann dabei einen beliebigen, insbesondere aber rechteckigen oder allgemein eckigen, Querschnitt aufweisen. Das Strangprofil weist jeweils sich in Längsrichtung erstreckende Lager und Gegenlager auf, zwischen denen ein Schaltungsträger, insbesondere eine Leiterplatte, eingebracht werden kann. Durch eine Verformung des Gehäusegrundkörpers lässt sich der Abstand zwischen Lager und Gegenlager verringern, so dass der Schaltungsträger beidseitig von einer Halterung gefasst ist, die von Lager und Gegenlager gebildet wird. Bei diesem Gehäuse genügt es daher, den Grundkörper zu verformen, um den Schaltungsträger im Gehäuse zu befestigen. Es sind daher keine zusätzlichen Teile, wie Schrauben oder Nieten, erforderlich.

Da sich ferner das Lager und das Gegenlager in Längsrichtung des Strangprofils erstrecken, kann das Lager und Gegenlager durch die Wahl eines geeigneten Querschnittsprofils beim Strangpressen hergestellt werden. Vielmehr besteht die Möglichkeit, das Gegenlager durch die Wahl eines geeigneten Querschnittprofils beim Strangpressen so auszubilden, dass der stranggepresste Gehäusegrundkörper unmittelbar nach dem Zuschnitt aus dem Strangprofil zur Aufnahme des Schaltungsträgers bereit ist.

So ist bei einer bevorzugten Ausführungsform das Gegenlager beispielsweise von einer sich im Inneren des Gehäusegrundkörpers in Längsrichtung erstreckenden Federleiste gebildet, die zum Befestigen des Schaltungsträgers auf diesen aufquetschbar ist. Diese Ausführungsform bietet den Vorteil, dass das Querschnittsprofil der Außenwände des Gehäusegrundkörpers nicht verändert wird, so dass der Gehäusegrundkörper problemlos abgedichtet werden kann.

Bei einer weiteren bevorzugten Ausführungsform ist das Gegenlager mit einer Blattfeder versehen, die nach der plastischen Verformung des Gehäusegrundkörpers am Schaltungsträger anliegt. Bei diesem Ausführungsbeispiel ist die Blattfeder nach der Montage des Schaltungsträgers elastisch verformt. Die auf den Schaltungsträger einwirkende Haltekraft wird daher im Wesentlichen von der Blattfeder und nicht von einem elastisch verformten Bereich des Gehäusegrundkörpers aufgebracht. Die elastischen Eigenschaften der Blattfeder können an die jeweiligen Erfordernisse bezüglich der Haltekraft angepasst werden. Insbesondere kann ein geeigneter Werkstoff ausgewählt werden, dessen elastische Eigenschaften den Anforderungen entsprechen.

Das Gegenlager kann auch durch eine Verformung der Außenwand des Gehäusegrundkörpers in Kontakt mit dem Schaltungsträger gebracht werden. Dabei sind verschiedene Ausführungsformen möglich.

Bei einer bevorzugten Ausführungsform wird die Außenwand des Gehäuses in Richtung einer Flächennormalen des Schaltungsträgers verformt, indem beispielsweise Seitenwände des Gehäusegrundkörpers gestaucht werden. Das Gegenlager kann dabei von einer federnden Leiste gebildet sein, die an einer dem Schaltungsträger gegenüberliegenden Außenwand des Gehäuses befestigt ist.

Bei einer abgewandelten Ausführungsform ist das Gegenlager als Steg ausgebildet, der über einen federnden Sockel an einer dem Schaltungsträger gegenüberliegenden Außenwand des Gehäusegrundkörpers befestigt ist. Diese Ausführungsform hat den Vorteil, dass der Anpresssteg mit seiner Schmalseite auf den Schaltungsträger drückt, so dass auf dem Schaltungsträger viel Platz für elektronische Bauelemente bleibt.

Um eine definierte Stauchung der Seitenwände des Gehäusegrundkörpers zu gewährleisten, können in den Seitenwänden des Gehäusegrundkörpers Schlitze vorgesehen sein, die durch Verbindungswulste überbrückt sind. Während des Stauchvorgangs werden die Verbindungswulste so lange verformt, bis die Trennschlitze geschlossen sind und die Teilbereiche der Seitenwände aneinander stoßen.

Bei einer abgewandelten Ausführungsform sind in einer quer zur Stauchrichtung verlaufenden Seite des Grundkörpers Greif- und Festhaltebereiche vorgesehen, die ein Aufziehen des Gehäusegrundkörpers erlauben. Dies gestattet, die Halterung für den Schaltungsträger spanlos ohne Beschädigung des Schaltungsträgers zu öffnen, so dass der Schaltungsträger aus dem Gehäusegrundkörper entnommen werden kann. Dies ist insbesondere dann nützlich, wenn Reparaturen am Schaltungsträger durchgeführt werden müssen.

Um ein Öffnen des Gehäusegrundkörpers zu ermöglichen, können in den gestauchten Seitenwänden auch Aufspreizbereiche vorgesehen sein, die ein Aufspreizen des Gehäusegrundkörpers gestatten.

Neben einer stauchbaren Ausgestaltung der Seitenwände kommt auch eine Ausgestaltung der Seitenwände in Betracht, bei der diese knick- oder faltbar sind. Bei einer derartigen Ausführungsform ist eine Federleiste an einem Wandabschnitt befestigt, der durch den Knick- oder Faltvorgang zum Schaltungsträger hin geneigt wird, so dass die Federleiste mit dem Schaltungsträger in Berührung kommt. Die Herstellung eines derartigen Gehäusegrundkörpers ist besonders einfach, da beim Strangpressen eines derartigen Gehäusegrundkörpers das Strangpresswerkzeug besonders stabil und steif hergestellt werden kann, so dass sich ein sicherer Extrusionsvorgang ergibt.

Weitere Einzelheiten und Vorteile werden nachfolgend anhand der in der Zeichnung dargestellten Ausführungsbeispiele im Einzelnen erläutert. Es zeigen:
- Figur 1: eine perspektivische Ansicht eines geöffneten Schaltungsmoduls mit einer auf einer Leiterplatte angeordneten Kraftfahrzeugschaltung;
- Figur 2A und 2B: Querschnittsdarstellungen durch das Schaltungsmodul aus Figur 1 vor und nach dem Befestigen der Leiterplatte;
- Figur 3A und 3B: Querschnitte durch ein abgewandeltes Schaltungsmodul, in dessen Gehäusegrundkörper die Leiterplatte mit Hilfe von Blattfedern gehalten ist;
- Figur 4A und 4B: Querschnitte durch den Gehäusegrundkörper eines abgewandelten Schaltungsmoduls, bei dem die Außenwand des Gehäusegrundkörpers für die Befestigung der Leiterplatte deformierbar ist;
- Figur 5A und 5B: Querschnitte durch ein abgewandeltes Ausführungsbeispiel eines Schaltungsmo duls, bei dem die Außenwand des Gehäusegrundkörpers deformierbar ist und die Leiterplatte im Gehäusegrundkörper durch Blattfedern niedergehalten ist;
- Figur 6A und 6B: Querschnitte durch eine stauchbare Seitenwand eines Gehäusegrundkörpers vor und nach dem Befestigen der Leiterplatte;
- Figur 7A und 7B: perspektivische Ansichten des Gehäusegrundkörpers aus den Figuren 6A und 6B vor und nach dem Stauchen der Seitenwände;
- Figur 8A und 8B: Querschnitte durch eine weitere stauchbare Seitenwand eines Gehäusegrundkörpers vor und nach dem Befestigen der Leiterplatte;
- Figur 9: eine perspektivische Ansicht des Gehäusegrundkörpers aus Figur 8A und 8B nach dem Stauchen der Seitenwand;
- Figur 10A bis 10C: Querschnitte durch eine abgewandelte stauchbare Seitenwand vor dem Aufziehen, nach dem Befestigen der Leiterplatte und nach dem erneuten Öffnen;
- Figur 11: eine perspektivische Ansicht des Gehäusegrundkörpers aus den Figuren 10A bis 10C vor dem Aufziehen;
- Figur 12: eine Querschnittsansicht durch eine weitere abgewandelte gestauchte Seitenwand nach dem Befestigen der Leiterplatte; und
- Figur 13: eine perspektivische Ansicht des Ausschnitts aus dem Gehäusegrundkörper aus Figur 12.

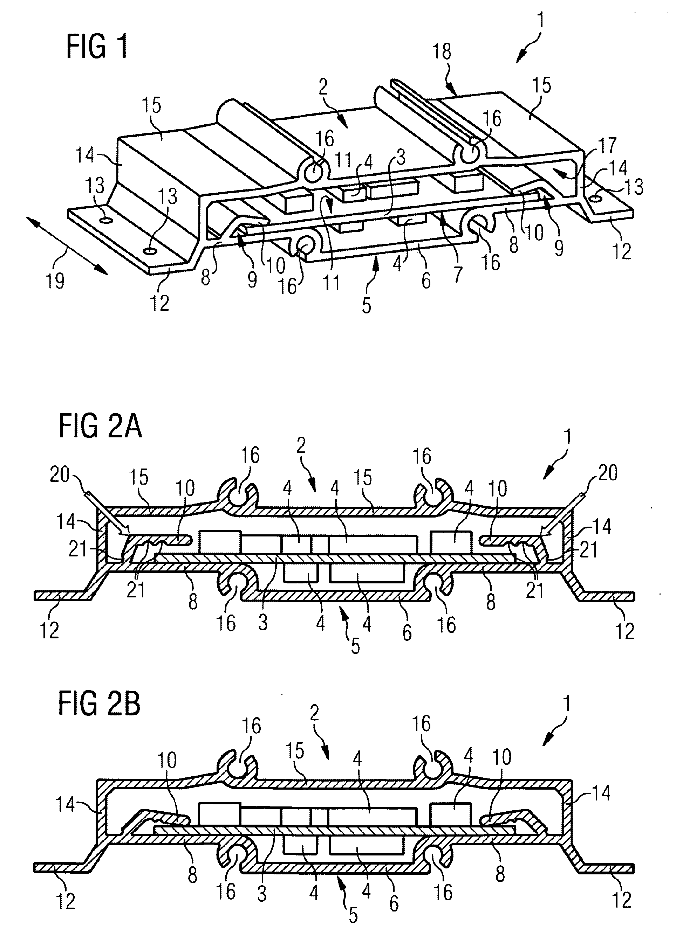

Figur 1 zeigt eine perspektivische Ansicht eines geöffneten Schaltungsmoduls 1, das einen Gehäusegrundkörper 2, vorzugsweise aus Metall, mit einer darin befestigten Leiterplatte 3 aufweist. Die Leiterplatte 3 ist beidseitig mit elektronischen Bauelementen 4 bestückt.

Der Gehäusegrundkörper 2 verfügt über eine mehrgliedrig gestaltete Bodenplatte 5. In einem mittleren Bereich verfügt die Bodenplatte 5 über eine Grundplatte 6, die die auf einer Unterseite 7 der Leiterplatte 3 angebrachte Bauelemente 4 überdeckt. Seitlich an die Grundplatte 6 schließen sich erhöhte Schultern 8 an, die Auflageflächen 9 für die Leiterplatte 3 bereitstellen. Von den Schultern 8 gehen auch Federleisten 10 aus, die die Leiterplatte 3 auf einer Oberseite 11 berühren. Seitlich an die Schultern 8 sind Flansche 12 mit Bohrungen 13 angesetzt. Die Bohrungen 13 dienen der Befestigung des Schaltungsmoduls 1 auf einer in Figur 1 nicht dargestellten Unterlage.

Von der Bodenplatte 5 des Gehäusegrundkörpers 2 gehen im Übergangsbereich zwischen den Flanschen 12 und den Schultern 8 Seitenwände 14 aus, die an ihrem Ende jeweils in eine sich über der Leiterplatte 3 erstreckende Abdeckplatte 15 übergehen. Der Gehäusegrundkörper 2 weist insgesamt die Form eines Hohlprofils auf, das unterbrechungsfrei um den Schaltungsträger 3 umläuft. Das Hohlprofil kann dabei einen beliebigen, insbesondere aber eckigen, Querschnitt aufweisen.

An der Bodenplatte 5 und der Abdeckplatte 15 sind Schraubenlöcher 16 vorgesehen, in die selbstschneidende Schrauben für die Befestigung von Abdeckungen einschraubbar sind, die eine vorderseitige Öffnung 17 und eine rückseitige Öffnung 18 des Gehäusegrundkörpers 2 abdecken. Anstelle von selbstschneiden den Schrauben können auch Nieten oder andere Befestigungsmittel verwendet werden.

Der Gehäusegrundkörper 2 ist durch Abteilen eines Strangprofils hergestellt. Folglich erstrecken sich die Federleisten 10 in eine Längsrichtung 19 über die gesamte Länge des Gehäusegrundkörpers 2. Die Leiterplatte 3 wird daher von den Federleisten 10 entlang ihrer gesamten Längsseite gehalten.

Figur 2A und Figur 2B zeigen Querschnitte durch den Gehäusegrundkörper 2 aus Figur 1. In Figur 2A ist der Zustand vor dem Befestigen der Leiterplatte 3 dargestellt. Figur 2B zeigt dagegen den Zustand des Gehäusegrundkörpers 2 nach dem Befestigen der Leiterplatte 3. Zur Befestigung der Leiterplatte 3 wird die Leiterplatte 3 zwischen den Schultern 8 und den Federleisten 10 in den Gehäusegrundkörper 2 eingeschoben. Um einen zuverlässigen Wärmeübergang von der Leiterplatte 3 auf den Gehäusegrundkörper 2 zu gewährleisten und um eine vibrationsfeste Verbindung zwischen der Leiterplatte 3 und dem Gehäusegrundkörper 2 zu bewerkstelligen, werden die Federleisten 10 mit einer Quetschkraft 20 beaufschlagt. Durch die Quetschkraft 20 werden die Federleisten 10 verformt, bis sie auf der Leiterplatte 3 federnd aufliegen. Die Federleisten 10 werden sowohl plastisch als auch elastisch verformt, wobei die Federleisten 10 so dimensioniert sind, dass auch nach dem Absetzen der Quetschkraft 20 eine die Leiterplatte 3 in ihrer Position haltende Federkraft auf die Leiterplatte 3 einwirkt. Bei der Dimensionierung der Federleisten 10 ist zu berücksichtigen, dass die Federleisten 10 eine Rückwärtsbewegung nach dem Absetzen der Quetschkraft 20 ausgleichen müssen.

Um die plastisch-elastische Verformung der Federleisten 10 zu erleichtern, sind an den Federleisten 10 Schwachstellen 21 ausgebildet, die eine definierte plastische Verformung der Federleisten 10 gewährleisten.

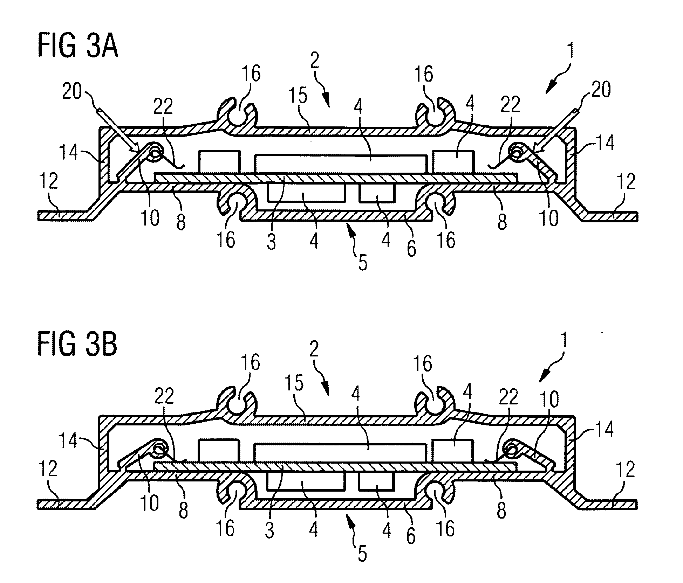

In den Figuren 3A und 3B sind Querschnitte durch eine abgewandelte Ausführungsform des Gehäusegrundkörpers 2 dargestellt. Bei dieser Ausführungsform sind die Federleisten 10 an ihrem der Leiterplatte 3 zugewandten Ende mit Federn 22 versehen, bei denen es sich beispielsweise um Blattfedern handeln kann. Zur Montage der Leiterplatte 3 wird diese zwischen den Schultern 8 und den Federn 22 in den Gehäusegrundkörper 2 eingeschoben. Durch Anwenden der Quetschkraft 20 werden dann die Federleisten 10 verformt, bis die Federn 22 eine ausreichend große Haltekraft auf die Leiterplatte 3 ausüben.

Bei dieser Ausführungsform besteht kaum die Gefahr, dass die Federleisten 10 überdrückt werden und die Leiterplatte 3 beim Anwenden der Quetschkraft 20 beschädigt wird. Außerdem kann der Werkstoff für die Feder 22 an die jeweiligen Anforderungen angepasst werden. Demgegenüber können die elastischen Eigenschaften der Federleisten 10 nur eingeschränkt angepasst werden, da der zur Herstellung des Gehäusegrundkörpers 2 verwendete Extrusionsvorgang die Materialauswahl einschränkt. Denn die elastischen Eigenschaften der Federleisten 10 des Ausführungsbeispiels aus den Figuren 1 sowie 2A und 2B können im Wesentlichen nur durch die geometrische Gestaltung der Federleisten 10 beeinflusst werden.

Bei dem Ausführungsbeispiel aus den Figuren 3A und 3B können die Federn 22 ferner so ausgebildet werden, dass die Leiterplatte 3 nicht entlang der gesamten Längsseite erfasst wird. So können beispielsweise bestimmte, für die Bauelemente 4 benötigte Bereiche der Leiterplatte 3 von den Federn 22 ausgespart werden, in denen dann weitere Bauelemente 4 oder weitere Entflechtungselemente untergebracht werden können.

Die in den Figuren 1, 2A und 2B sowie 3A und 3B dargestellten Ausführungsbeispiele zeichnen sich dadurch aus, dass die Befestigung der Leiterplatten 3 ohne eine Deformation der Außenwände des Gehäusegrundkörpers 2 vorgenommen werden kann.

Die Außenwände des Gehäusegrundkörpers 2 behalten somit ihr definiertes Querschnittsprofil bei. Dies ist insbesondere dann von Vorteil, wenn es auf die Dichtigkeit des fertigen Schaltungsmoduls 1 ankommt. Denn aufgrund des definierten Querschnittsprofils der Außenwände können auch genau passende Dichtungen auf die vorderseitige Öffnung 17 und die rückseitige Öffnung 18 aufgebracht werden, die den Gehäusegrundkörper 2 zuverlässig abdichten.

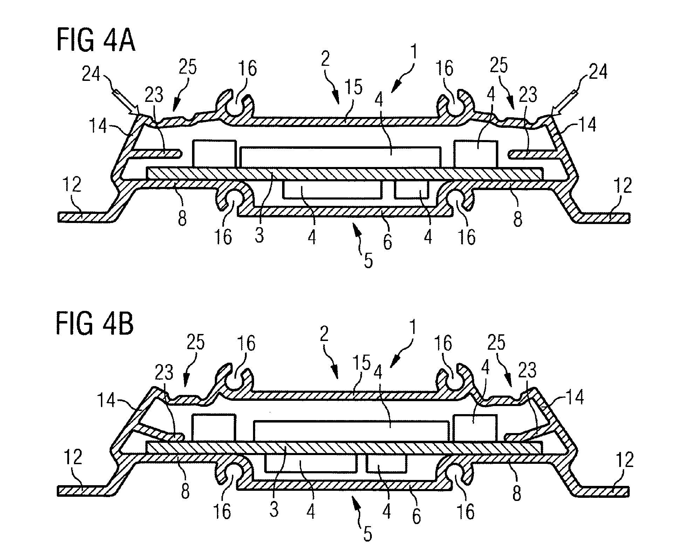

Es ist jedoch auch möglich, wie in den Figuren 4A und 4B dargestellt, eine Halterung für die Leiterplatte 3 über eine Verformung der Seitenwände 14 oder der Abdeckplatte 15 zu bewerkstelligen. Bei dem in den Figuren 4A und Figur 4B dargestellten Ausführungsbeispiel sind die Federleisten 23 an den Seitenwänden 14 ausgebildet. Wenn die Seitenwände 14 durch Anwenden einer Quetschkraft 24 nach innen gekippt werden, kommen die Federleisten 23, wie in Figur 4B dargestellt, in Berührung mit der Leiterplatte 3. Die Seitenwände 14 werden so weit verformt, bis eine ausreichend große federnde Haltekraft auf die Leiterplatte 3 einwirkt.

Um das Verkippen der Seitenwände 14 zu ermöglichen, sind in der Abdeckplatte 15 definierte Verformungsbereiche 25 vorgesehen. Die Verformungsbereiche 25 knicken beim Verkippen der Seitenwände 14 etwas ein und verkürzen die Abdeckplatte 15.

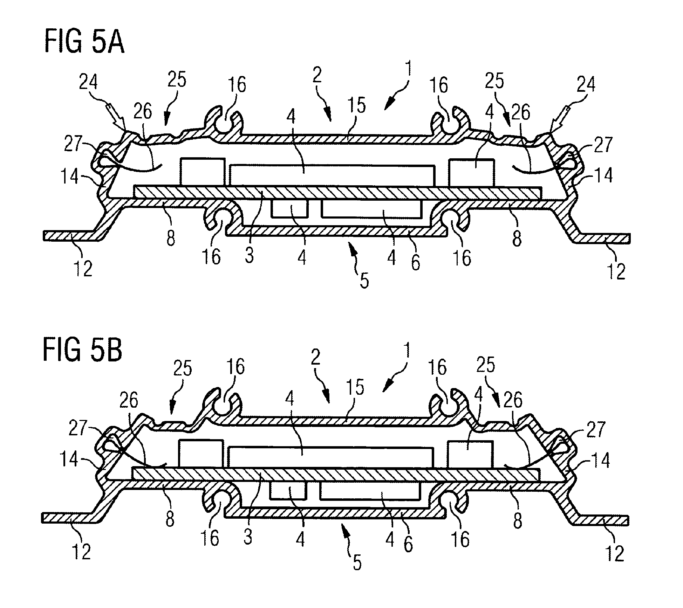

Anstelle der Federleisten 23 können auch Federn 26 an den Seitenwänden 14 angebracht sein. Ein derartiges Ausführungsbeispiel ist in den Figuren 5A und Figur 5B vor und nach dem Befestigen der Leiterplatte 3 dargestellt. Bei diesem Ausführungsbeispiel weisen die Seitenwände Haltenuten 27 auf, in denen die Federn 26 gehalten sind.

Das in den Figuren 5A und Figur 5B dargestellte Ausführungsbeispiel weist wie das in den Figuren 3A und Figur 3B dargestellte Ausführungsbeispiel den Vorteil auf, dass der Werk stoff für die Federn 26 an die jeweiligen Anforderungen angepasst werden kann.

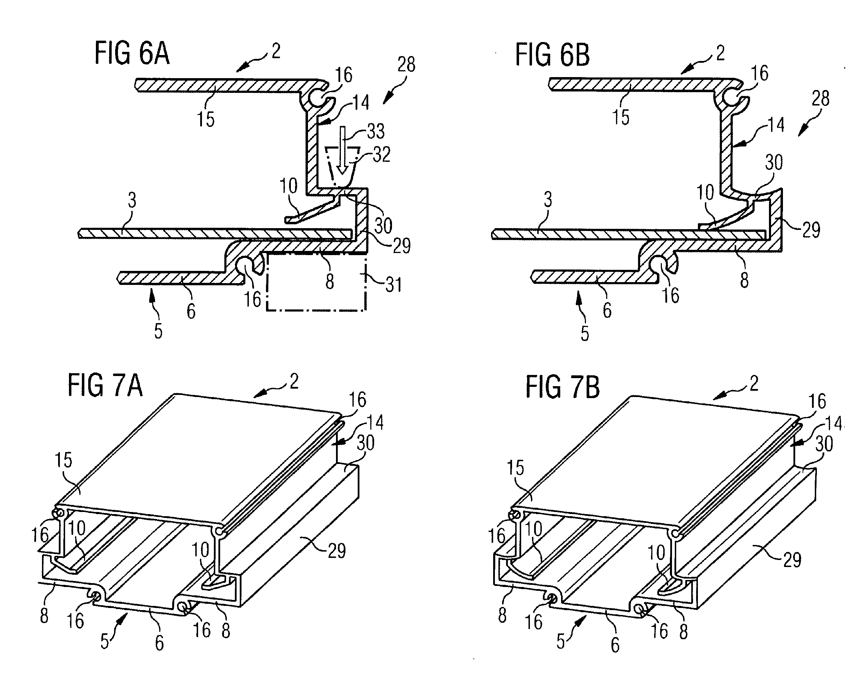

Ein weiteres Ausführungsbeispiel mit verformbaren Außenwänden ist in Figur 6A und 6B sowie in Figur 7A und Figur 7B dargestellt.

In Figur 6A ist die Seitenwand 14 eines Ausführungsbeispiels des Gehäusegrundkörpers im Querschnitt dargestellt. Bei diesem Ausführungsbeispiel des Gehäusegrundkörpers 2 ist die Seitenwand 14 treppenförmig ausgebildet. Sie verfügt insbesondere über eine Stufe 28 mit einer Stufenwand 29 und einer Stufendecke 30. Die Federleiste 10 erstreckt sich von der Stufendecke 30 ausgehend in das Innere des Gehäusegrundkörpers 2. Zum Befestigen der Leiterplatte 3 im Gehäusegrundkörper 2 wird diese in das Innere des Gehäusegrundkörpers 2 zwischen der Schulter 8 und der Federleiste 10 eingebracht. Die Schulter 8 wird dann auf einen in Figur 6A gestrichelt eingezeichneten Amboss 31 aufgelegt und die Stufendecke 30 mit Hilfe eines Stößels 32 eingedrückt. Mit Hilfe des Stößels 32 wird die Stufendecke 30 mit einer Eindrückkraft 33 beaufschlagt. Dadurch wird auch die Federleiste 10 abgesenkt, bis diese die Leiterplatte 3 federnd kontaktiert.

In Figur 7A und Figur 7B sind perspektivische Ansichten des Ausführungsbeispiels des Gehäusegrundkörpers 2 aus den Figuren 6A und Figur 6B dargestellt.

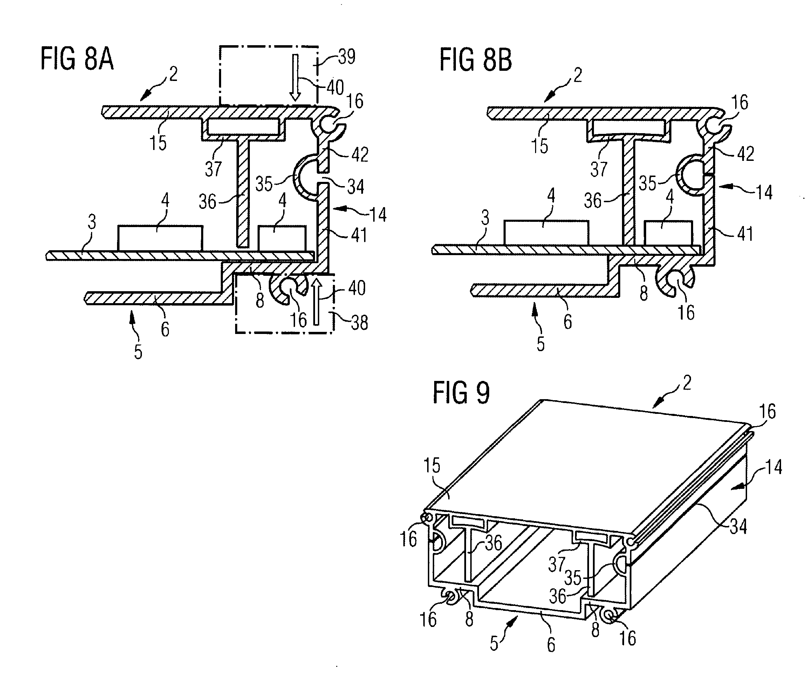

Figur 8A und 8B zeigen Querschnitte durch ein abgewandeltes Ausführungsbeispiel des Gehäusegrundkörpers 2 mit einer Seitenwand 14, in die ein sich über die gesamte Längsseite erstreckender Längsschlitz 34 eingebracht ist. Der Längsschlitz 34 ist innenseitig durch einen deformierbaren Verbindungswulst 35 überbrückt. Im Inneren des Gehäusegrundkörpers 2 befindet sich ferner ein Anpresssteg 36, der über ein sockelartiges Hohlprofil 37 an der Abdeckplatte 15 angebracht ist. Zum Befestigen der Leiterplatte 3 wird die Schulter 8 auf einen Amboss 38 aufgelegt und ein weiterer Amboss 39 auf die von der Abdeckplatte 15 gebildete obere Außenwand des Gehäusegrundkörpers 2 aufgebracht. Die Ambosse 38 und 39 bringen jeweils eine Presskraft 40 auf, die die Seitenwand 14 staucht. Dadurch wird der Verbindungswulst 35 deformiert und der Längsschlitz 34 geschlossen. Ein unterer Wandabschnitt 41 bildet dabei einen Anschlag für einen oberen Wandabschnitt 42. Dadurch wird eine übermäßige Deformation der Seitenwand 14 und des Hohlprofils 37 verhindert.

Da bei diesem Ausführungsbeispiel lediglich die Schmalseite des Anpressstegs 36 auf die Leiterplatte 3 drückt, bleibt auf der Leiterplatte 3 im Vergleich zu den vorhergehenden Ausführungsbeispielen mehr Platz für die elektronischen Bauelemente 4.

Durch die Kompression der Seitenwand 14 wird der Abstand zwischen der Schulter 8 und der oberen Abdeckplatte 15 verringert und das Hohlprofil 37 derart eingedrückt, dass der Anpresssteg 36 an der Leiterplatte 3 federnd anliegt.

In Figur 9 ist eine perspektivische Ansicht des Gehäusegrundkörpers 2 aus den Figuren 8A und 8B nach dem Befestigen der Leiterplatte 3 dargestellt.

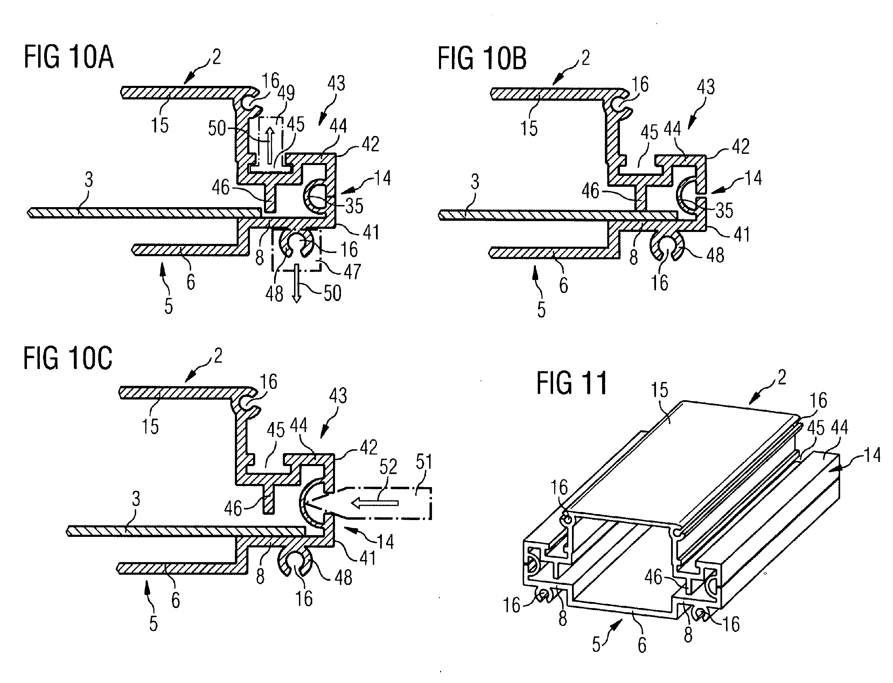

Figur 10A bis Figur 10C zeigen Ausschnitte aus einem Querschnitt durch einen abgewandelten Gehäusegrundkörper 2, dessen Seitenwand 14 ebenfalls durch den Längsschlitz 34 in einen unteren Wandabschnitt 41 und einen oberen Wandabschnitt 42 unterteilt ist. Die Seitenwände des in den Figuren 10A bis Figur 10C dargestellten Ausführungsbeispiels des Gehäusegrundkörpers 2 sind ferner treppenförmig mit einer Stufe 43 ausgebildet, in deren Stufendeckel 44 eine Haltenut 45 ausgebildet ist. An dem Stufendeckel 44 ist auch ein Anpresssteg 46 angebracht, der im vormontierten Zustand nahezu an der Schulter anliegt, so dass die Leiterplatte 3 zunächst nicht zwischen die Schulter 8 und den Anpresssteg 46 eingebracht werden kann. Der Gehäusegrundkörper 2 muss daher erst aufgezogen werden. Dies wird dadurch bewerkstelligt, dass ein unteres Aufziehwerkzeug 47 an einem außen an der Schulter 8 angebrachten Wulst 48 angreift und ein oberes Aufziehwerkzeug in die hinterschnittene Haltenut 45 eingebracht wird. Durch Anwenden einer Aufziehkraft 50 kann der Gehäusegrundkörper 2 aufgezogen werden. Der Gehäusegrundkörper befindet sich dann in dem in Figur 10B dargestellten Zustand, in dem die Leiterplatte 3 zwischen die Schulter 8 und den Anpresssteg 46 eingebracht werden kann. Anschließend kann der Gehäusegrundkörper 2 erneut komprimiert werden, bis der Anpresssteg 46 an der Leiterplatte 3 federnd anliegt. Die Federkraft wird dabei vom Verbindungswulst 35 aufgebracht.

In Figur 10C ist schließlich der Fall dargestellt, in dem ein Aufspreizwerkzeug 51 unter Anwendung einer Aufspreizkraft 52 in den Längsschlitz 34 hineingetrieben wird, um den Gehäusegrundkörper 2 soweit aufzuspreizen, dass die Leiterplatte 3 entnommen werden kann. Dies ist insbesondere dann nützlich, wenn die Leiterplatte 3 für Reparaturzwecke aus dem Gehäusegrundkörper 2 entnommen werden muss.

Daneben ist es auch möglich, den Gehäusegrundkörper 2 nach dem Einklemmen der Leiterplatte 3 mit Hilfe der Aufziehwerkzeuge 47 und 49 erneut aufzuziehen.

Diese Verfahren ermöglichen ein spanfreies Öffnen des Gehäusegrundkörpers 2, so dass keine Zerstörung der Leiterplatte 3 befürchtet werden muss.

In Figur 11 ist der Gehäusegrundkörper 2 aus den Figuren 10A bis 10C der Deutlichkeit halber in einer perspektivischen Ansicht dargestellt.

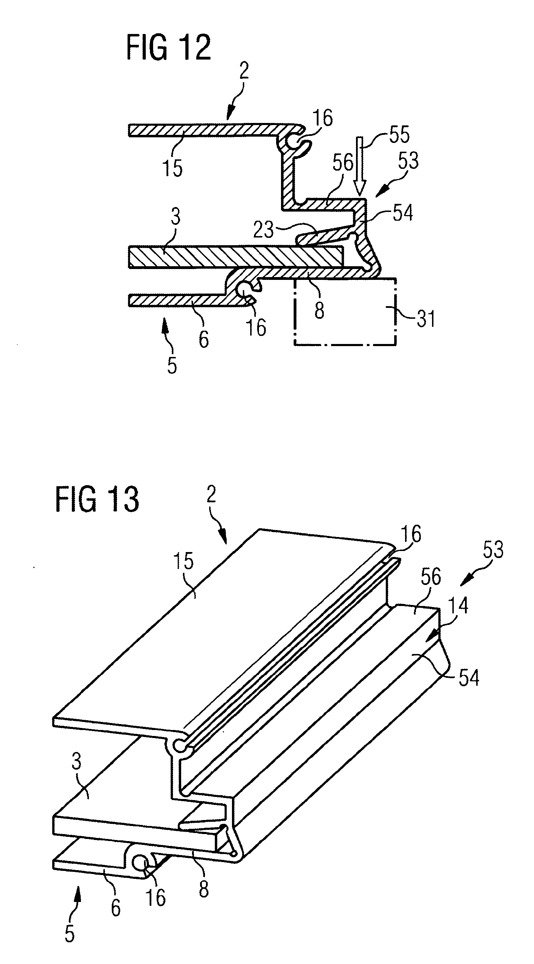

In Figur 12 ist schließlich ein abgewandeltes Ausführungsbeispiel des Gehäusegrundkörpers 2 dargestellt, bei dem die Seitenwand 14 ebenfalls treppenförmig ausgebildet ist. Die Seitenwand 14 in dem in Figur 12 dargestellten Ausführungsbeispiel weist eine Stufe 53 mit einer einknickbaren Stufenwand 54 auf, an der die Federleiste 23 angebracht ist. Beim Anwenden einer Presskraft 55 auf eine Stufendecke 56 wird die Stufe 53 komprimiert und die Stufenwand 54 knickt ein. Dadurch wird das der Leiterplatte 3 zugewandte Ende der Federleiste 23 abgesenkt, bis die Federleiste 23 an der Leiterplatte 3 federnd anliegt.

Figur 13 zeigt eine perspektivische Darstellung dieses Ausführungsbeispiels.

Das Ausführungsbeispiel des Gehäusegrundkörpers 2 aus den Figuren 12 und 13 hat den Vorteil, dass das Extrusionswerkzeug zur Herstellung des Gehäusegrundkörpers 2 besonders stabil und betriebssicher hergestellt werden kann, da die Federleiste 23 bei dem Ausführungsbeispiel des Gehäusegrundkörpers aus den Figuren 12 und 13 im ursprünglichen Zustand im Wesentlichen parallel zur Schulter 8 und der Stufendecke 56 ausgerichtet ist.

Es sei angemerkt, dass die in Figur 10A bis Figur 10C dargestellten Ansatzpunkte für die Anwendung einer den Gehäusegrundkörper 2 aufspreizenden Aufspreizkraft auch bei den anderen in den übrigen Figuren dargestellten Ausführungsbeispielen des Gehäusegrundkörpers 2 vorhanden sein können.

## Patentansprüche

1. Gehäuse für die Aufnahme eines Schaltungsträgers (3) mit einem Gehäusegrundkörper (2), der ein Lager (8) und ein Gegenlager (10, 22, 23, 26, 36, 37, 46) aufweist, die nach einer den Abstand zwischen Lager (8) und Gegenlager (10, 22, 23, 26, 36, 37,46) verringernden Verformung des Gehäusegrundkörpers (2) eine den Schaltungsträger (3) beidseitig fassende Halterung bilden,
**dadurch gekennzeichnet,**
**dass** der Gehäusegrundkörper (2) aus einem Strangprofil hergestellt und in Form eines Hohlprofils ausgestaltet ist, und
**dass** das Lager (8) und das Gegenlager (10, 22, 23, 26, 36, 37, 46), die sich in eine Längsrichtung (19) im Inneren des Gehäusegrundkörpers (2) erstrecken, nach der Verformung des Gehäusegrundkörpers (2) eine federnde Halterung für den Schaltungsträger (3) bilden.

2. Gehäuse nach Anspruch 1,
**dadurch gekennzeichnet, dass**
das Lager von einer Schulter (8) der Außenwand des Gehäusegrundkörpers (2) gebildet ist.

3. Gehäuse nach Anspruch 1 oder 2,
**dadurch gekennzeichnet, dass**
das Gegenlager von einer stranggepressten, plastisch und elastisch verformbaren Federleiste (10, 23) gebildet ist.

4. Gehäuse nach Anspruch 1 oder 2,
**dadurch gekennzeichnet, dass**
das Gegenlager ein auf den Schaltungsträger (3) aufbringbares Federelement (22, 26) umfasst.

5. Gehäuse nach Anspruch 4,
**dadurch gekennzeichnet, dass**
das Federelement (22) an einer plastisch verformbaren Federleiste (10) befestigt ist.

6. Gehäuse nach Anspruch 4,
**dadurch gekennzeichnet, dass**
das Gegenlager ein auf den Schaltungsträger (3) aufbringbares Federelement (26) ist.

7. Gehäuse nach einem der Ansprüche 4 bis 6,
**dadurch gekennzeichnet, dass**
in dem Federelement (22, 26) Aussparungen für auf dem Schaltungsträger (3) angeordnete Bauelemente (4) vorgesehen sind.

8. Gehäuse nach einem der Ansprüche 1 bis 7,
**dadurch gekennzeichnet, dass**
der Schaltungsträger (3) durch bloßes Verformen des Gegenlagers (10, 22) ohne Verformung des Querschnittsprofils der Außenwände (5, 6, 8, 14, 15) im Gehäusegrundkörper (2) befestigbar ist.

9. Gehäuse nach einem der Ansprüche 1 bis 7,
**dadurch gekennzeichnet, dass**
das Gegenlager (23, 26) durch ein Verkippen einer Seitenwand (14) des Gehäusegrundkörpers (2) in Richtung des Schaltungsträgers (3) an den Schaltungsträger (3) anlegbar ist.

10. Gehäuse nach einem der Ansprüche 1 bis 7,
**dadurch gekennzeichnet, dass**
der Gehäusegrundkörper (2) quer zur Flächenausdehnung des Schaltungsträgers (3) verformbar ist.

11. Gehäuse nach Anspruch 10,
**dadurch gekennzeichnet, dass**
der Gehäusegrundkörper (2) annähernd in Richtung einer Flächennormalen des Schaltungsträgers (3) verformbar ist.

12. Gehäuse nach Anspruch 10 oder 11,
**dadurch gekennzeichnet, dass**
der Gehäusegrundkörper (2) in einer Seitenwand (14) einen Längsschlitz (34) aufweist, der mit Hilfe eines zur Befestigung des Schaltungsträgers (3) verformbaren Verbindungselement (35) überbrückt ist.

13. Gehäuse nach Anspruch 12,
**dadurch gekennzeichnet, dass**
ein unterer Wandabschnitt (41) und ein oberer Wandabschnitt (42) der Seitenwand (14) jeweils als Anschlag beim Deformieren der Seitenwand 14 dienen.

14. Gehäuse nach Anspruch 10 oder 11,
**dadurch gekennzeichnet, dass**
ein dem Schaltungsträger (3) gegenüberliegender und innenseitig mit dem Gegenlager (10) versehener Stufendecke (30) der Außenwand des Gehäusegrundkörpers (2) zum Befestigen der Leiterplatte (3) eindrückbar ist.

15. Gehäuse nach einem der Ansprüche 10 bis 14,
**dadurch gekennzeichnet, dass**
das Gegenlager ein annähernd in Richtung einer Flächennormalen des Schaltungsträgers (3) auf den Schaltungsträger (3) einwirkender Anpresssteg (36, 46) ist.

16. Gehäuse nach Anspruch 15,
**dadurch gekennzeichnet, dass**
der Anpresssteg (36) über ein zum Befestigen des Schaltungsträgers (3) elastisch verformbares Hohlprofil (37) an der Außenwand des Gehäusegrundkörpers (2) angebracht ist.

17. Gehäuse nach einem der Ansprüche 9 bis 16,
**dadurch gekennzeichnet, dass**
an den Außenwänden (5, 6, 8, 14, 15, 29, 30, 44, 54, 56) Haltemittel (45, 48) ausgebildet sind, an die Aufziehkräfte (50) ansetzbar ist, die den Gehäusegrundkörper verformen.

18. Gehäuse nach einem der Ansprüche 9 bis 17,
**dadurch gekennzeichnet, dass** ein Aufspreizwerkzeug (51) in einen Längsschlitz (34) in der Außenwand (5, 6, 8, 14, 15, 29, 30, 44, 51, 56) hineingetrieben ist, das den Gehäusegrundkörper aufspreizt.

19. Verfahren zur Herstellung eines Schaltungsmoduls (1) mit den Verfahrensschritten:
- Strangpressen eines Gehäusegrundkörpers (2), der im Inneren mit einem Lager (8) und einem Gegenlager (10, 22, 23, 26, 36, 37, 46) versehen ist;
- Einbringen eines Schaltungsträgers (3) in den Gehäusegrundkörper (2);
- Durchführen einer den Abstand zwischen Lager (8) und Gegenlager (10, 22, 23, 26, 36, 37, 43) verringernden Verformung des Gehäusegrundkörpers (2) und dadurch Herstellen einer den Schaltungsträger (3) beidseitig fassenden Halterung,
**dadurch gekennzeichnet,**
**dass** der Gehäusegrundkörper (2) aus einem Strangprofil hergestellt wird und in Form eines Hohlprofils ausgestaltet ist und dass der Schaltungsträger (3) nach der Verformung des Gehäusegrundkörpers (2) vom Lager (8) und Gegenlager (10,22, 23, 26, 36, 37, 43), die sich in eine Längsrichtung (19) im Inneren des Gehäusegrundkörpers (2) erstrecken, federnd gehalten wird.

20. Verfahren nach Anspruch 19,
**dadurch gekennzeichnet, dass**
das Querschnittsprofil der Außenwände (5, 6, 8, 14, 15) des Gehäusegrundkörpers (2) während der Befestigung des Schaltungsträgers (3) unverändert belassen und das Gegenlager (10) durch eine plastische Deformation in federnden Kontakt mit dem Schaltungsträger (3) gebracht wird.

21. Verfahren nach Anspruch 19,
**dadurch gekennzeichnet, dass**
das Gegenlager (23, 26) an einer Seitenwand (14) des Gehäusegrundkörpers (2) ausgebildet sind und das Gegenlager (23, 26) durch Verkippen der Seitenwände (14) in Richtung des Schaltungsträgers (3) in federnden Kontakt mit dem Schaltungsträger (3) gebracht wird.

22. Verfahren nach Anspruch 19,
**dadurch gekennzeichnet, dass**
das Gegenlager (36, 46) an einer der Leiterplatte (3) gegenüberliegenden Außenwand des Gehäusegrundkörpers (2) ausgebildet wird und der Gehäusegrundkörper (2) zur Befestigung des Schaltungsträgers (3) in eine Richtung quer zur Flächenausdehnung des Schaltungsträgers (3) gestaucht wird.

## Claims

1. Housing for accommodating a circuit carrier (3), including a housing chassis (2) which has a mounting (8) and an opposing mounting (10, 22, 23, 26, 36, 37, 46) which form a holding arrangement that grips the circuit carrier (3) on both sides after a deformation of the housing chassis (2) which decreases the distance between mounting (8) and opposing mounting (10, 22, 23, 26, 36, 37, 46),
**characterised in that**
the housing chassis (2) is produced from an extruded profile and is embodied in the form of a hollow profile, and that the mounting (8) and the opposing mounting (10, 22, 23, 26, 36, 37, 46), these extending in a longitudinal direction (19) in the interior of the housing chassis (2), form a sprung holding arrangement for the circuit carrier (3) after the deformation of the housing chassis (2).

2. Housing according to claim 1,
**characterised in that**
the mounting is formed by a shoulder (8) of the external wall of the housing chassis (2).

3. Housing according to claim 1 or 2,
**characterised in that**
the opposing mounting is formed by an extruded spring strip (10, 23) which can be deformed both plastically and elastically.

4. Housing according to claim 1 or 2,
**characterised in that**
the opposing mounting comprises a spring element (22, 26) which can be brought into contact with the circuit carrier (3).

5. Housing according to claim 4,
**characterised in that**
the spring element (22) is fastened to a plastically deformable spring strip (10).

6. Housing according to claim 4,
**characterised in that**
the opposing mounting is a spring element (26) which can be brought into contact with the circuit carrier (3).

7. Housing according to one of claims 4 to 6,
**characterised in that**
gaps for components (4) which are arranged on the circuit carrier (3) are provided in the spring element (22, 26).

8. Housing according to one of claims 1 to 7,
**characterised in that**
the circuit carrier (3) can be fastened in the housing chassis (2) merely by deformation of the opposing mounting (10, 22), without deformation of the cross-sectional profile of the external walls (5, 6, 8, 14, 15).

9. Housing according to one of claims 1 to 7,
**characterised in that**
the opposing mounting (23, 26) can be brought into contact with the circuit carrier (3) by tilting a side wall (14) of the housing chassis (2) in the direction of the circuit carrier (3).

10. Housing according to one of claims 1 to 7,
**characterised in that**
the housing chassis (2) can be deformed transversely relative to the surface extension of the circuit carrier (3).

11. Housing according to claim 10,
**characterised in that**
the housing chassis (2) can be deformed approximately in the direction of a normal to the surface of the circuit carrier (3).

12. Housing according to claim 10 or 11,
**characterised in that**
the housing chassis (2) has a longitudinal slot (34) which is provided in a side wall (14) and is bridged by means of a connection element (35) that can be deformed for the purpose of fastening the circuit carrier (3).

13. Housing according to claim 12,
**characterised in that**
a lower wall section (41) and an upper wall section (42) of the side wall (14) in each case serve as a stop during deformation of the side wall (14).

14. Housing according to claim 10 or 11,
**characterised in that**
a step cover (30) of the external wall of the housing chassis (2), said step cover being situated opposite the circuit carrier (3) and being equipped with the opposing mounting (10) on its inner side, can be impressed for the purpose of fastening the printed circuit board (3).

15. Housing according to one of claims 10 to 14,
**characterised in that**
the opposing mounting is a pressure ridge (36, 46) which acts on the circuit carrier (3) in approximately the direction of a normal to the surface of the circuit carrier (3).

16. Housing according to claim 15,
**characterised in that**
the pressure ridge (36) is attached to the external wall of the housing chassis (2) by means of a hollow profile (37) which is elastically deformable for the purpose of fastening the circuit carrier (3).

17. Housing according to one of claims 9 to 16,
**characterised in that**
holding means (45, 48) to which pulling forces (50) which deform the housing chassis can be applied are embodied on the external walls (5, 6, 8, 14, 15, 29, 30, 44, 54, 56).

18. Housing according to one of claims 9 to 17,
**characterised in that**
a spreading tool (51) is driven into a longitudinal slot (34) in the external wall (5, 6, 8, 14, 15, 29, 30, 44, 54, 56) in order to spread open the housing chassis.

19. Method for producing a circuit module (1) comprising the following method steps:
- extruding a housing chassis (2) which is internally provided with a mounting (8) and an opposing mounting (10, 22, 23, 26, 36, 37, 46);
- inserting a circuit carrier (3) into the housing chassis (2);
- carrying out a distortion of the housing chassis (2) which decreases the distance between mounting (8) and opposing mounting (10, 22, 23, 26, 36, 37, 43), thereby producing a holding arrangement which grips the circuit carrier (3) on both sides,
**characterised in that**
the housing chassis (2) is produced from an extruded profile and is embodied in the form of a hollow profile, and that after the distortion of the housing chassis (2) the circuit carrier (3) is held in a sprung manner by means of the mounting (8) and opposing mounting (10, 22, 23, 26, 36, 37, 43), these extending in a longitudinal direction (19) in the interior of the housing chassis (2).

20. Method as claimed in claim 19,
**characterised in that**
the cross-sectional profile of the external walls (5, 6, 8, 14, 15) of the housing chassis (2) is left unchanged during the fastening of the circuit carrier (3) and the opposing mounting (10) is brought into sprung contact with the circuit carrier (3) by virtue of a plastic deformation.

21. Method as claimed in claim 19,
**characterised in that**
the opposing mounting (23, 26) is embodied on a side wall (14) of the housing chassis (2) and the opposing mounting (23, 26) is brought into sprung contact with the circuit carrier (3) by means of a tilting of the side walls (14) in the direction of the circuit carrier (3).

22. Method as claimed in claim 19,
**characterised in that**
the opposing mounting (36, 46) is formed on an external wall of the housing chassis (2), said external wall being opposite to the printed circuit board (3), and the housing chassis (2) is compressed in a transverse direction relative to the surface extension of the circuit carrier (3) for the purpose of fastening the circuit carrier (3).

## Revendications

1. Boîtier destiné à recevoir un support de circuit (3) et possédant un corps de base de boîtier (2) qui présente un appui (8) et un contre-appui (10, 22, 23, 26, 36, 37, 46) qui, après une déformation du corps de base de boîtier (2) qui réduit la distance entre l'appui (8) et le contre-appui (10, 22, 23, 26, 36, 37, 46), forment une fixation qui tient le support de circuit (3) sur les deux faces
**caractérisé en ce que**
le corps de base de boîtier (2) est fabriqué à partir d'un profilé extrudé et présente la forme d'un profilé creux, et **en ce que** l'appui (8) et le contre-appui (10, 22, 23, 26, 36, 37, 46) qui s'étendent dans une direction longitudinale (19) à l'intérieur du corps de base de boîtier (2) forment après la déformation du corps de base de boîtier (2) une fixation élastique pour le support de circuit (3).

2. Boîtier selon la revendication 1,
**caractérisé en ce que**
l'appui est formé par un épaulement (8) de la paroi extérieure du corps de base de boîtier (2).

3. Boîtier selon la revendication 1 ou 2,
**caractérisé en ce que**
le contre-appui est formé par une nervure élastique (10, 23) extrudé, susceptible de déformation plastique et élastique.

4. Boîtier selon la revendication 1 ou 2,
**caractérisé en ce que**
le contre-appui comprend un élément élastique (22, 26) pouvant être appuyé sur le support de circuit (3).

5. Boîtier selon la revendication 4,
**caractérisé en ce que**
l'élément élastique (22) est fixé à une nervure élastique (10) susceptible de déformation plastique.

6. Boîtier selon la revendication 4,
**caractérisé en ce que**
le contre-appui est un élément élastique (26) qui peut être appuyé sur le support de circuit (3).

7. Boîtier selon une des revendications 4 à 6,
**caractérisé en ce que**
dans l'élément élastique (22, 26) sont prévus des évidements pour des composants (4) disposés sur le support de circuit (3).

8. Boîtier selon une des revendications 1 à 7,
**caractérisé en ce que**
le support de circuit (3) peut être fixé dans le corps de base de boîtier (2) par simple déformation du contre-appui (10, 22) sans déformation du profil de section des parois extérieures (5, 6, 8, 14, 15).

9. Boîtier selon une des revendications 1 à 7,
**caractérisé en ce que**
le contre-appui (23, 26) peut être appuyé sur le support de circuit (3) par un basculement d'une paroi latérale (14) du corps de base de boîtier (2) en direction du support de circuit (3).

10. Boîtier selon une des revendications 1 à 7,
**caractérisé en ce que**
le corps de base de boîtier (2) peut être déformé transversalement à l'extension de la surface du support de circuit (3).

11. Boîtier selon la revendication 10,
**caractérisé en ce que**
le corps de base de boîtier (2) peut être déformé à peu près selon la direction d'une normale à la surface du support de circuit (3).

12. Boîtier selon la revendication 10 ou 11,
**caractérisé en ce que**
le corps de base de boîtier (2) présente dans une paroi latérale (14) une fente longitudinale (34) qui est recouverte à l'aide d'un élément de liaison (35) qui peut être déformé pour fixer le support de circuit (3).

13. Boîtier selon la revendication 12,
**caractérisé en ce qu'**
un segment de paroi inférieur (41) et un segment de paroi supérieur (42) de la paroi latérale (14) servent de butée lors de la déformation de la paroi latérale (14).

14. Boîtier selon la revendication 10 ou 11,
**caractérisé en ce que**
un giron de marche (30) de la paroi extérieure du corps de base de boîtier (2) qui fait face au support de circuit (3) et qui est muni du contre-appui (10) sur sa face intérieure, peut être enfoncé pour fixer la carte de circuit imprimé (3).

15. Boîtier selon une des revendications 10 à 14,
**caractérisé en ce que**
le contre-appui est une aile de pression (36, 46) qui agit sur le support de circuit (3) à peu près selon la direction d'une normale à la surface du support de circuit (3).

16. Boîtier selon la revendication 15,
**caractérisé en ce que**
l'aile de pression (36) est fixée à la paroi extérieure du corps de base de boîtier (2) par l'intermédiaire d'un profilé creux (37) qui peut être déformé élastiquement pour fixer le support de circuit (3).

17. Boîtier selon une des revendications 9 à 16,
**caractérisé en ce que**,
sur les parois extérieures (5, 6, 8, 14, 15, 29, 30, 44, 54, 56), sont formés des moyens de retenue (45, 48) auxquels on peut appliquer des forces d'ouverture (50) qui déforment le corps de base de boîtier.

18. Boîtier selon une des revendications 9 à 17,
**caractérisé en ce qu'**
un outil d'écartement (51) est engagé dans une fente longitudinale (34) de la paroi extérieure (5, 6, 8, 14, 15, 29, 30, 44, 54, 56) et écarte le corps de base de boîtier.

19. Procédé de fabrication d'un module de circuit (1), comprenant les étapes de procédé suivantes :
- extruder un corps de base de boîtier (2) qui est muni intérieurement d'un appui (8) et d'un contre-appui (10, 22, 23, 26, 36, 37, 46) ;
- mettre un support de circuit (3) en place dans le corps de base de boîtier (2) ;
- effectuer une déformation du corps de base de boîtier (2) qui réduit la distance entre l'appui (8) et le contre-appui (10, 22, 23, 26, 36, 37, 43) et former de cette façon une fixation qui tient le support de circuit (3) sur les deux faces,
**caractérisé en ce que**
le corps de base de boîtier (2) est fabriqué à partir d'un profilé extrudé et conformé à la façon d'un profilé creux et **en ce qu'**après la déformation du corps de base du boîtier (2), le support de circuit (3) est retenu élastiquement par l'appui (8) et par le contre-appui (10, 22, 23, 26, 36, 37, 43) qui s'étendent dans une direction longitudinale (19) à l'intérieur du corps de base de boîtier (2).

20. Procédé selon la revendication 19,
**caractérisé en ce que**
le profil de section des parois extérieures (5, 6, 8, 14, 15) du corps de base de boîtier (2) est laissé inchangé pendant la fixation du support de circuit (3) et le contre-appui (10) est mis en contact élastique avec le support de circuit (3) par une déformation plastique.

21. Procédé selon la revendication 19,
**caractérisé en ce que**
le contre-appui (23, 26) est formé sur une paroi latérale (14) du corps de base du boîtier (2) et le contre-appui (23, 26) est mis en contact élastique avec le support de circuit (3) en faisant basculer les parois latérales (14) en direction du support de circuit (3).

22. Procédé selon la revendication 19,
**caractérisé en ce que**
le contre-appui (36, 46) est formé sur une paroi extérieure du corps de base de boîtier (2) qui fait face au support de circuit (3), et, pour fixer le support de circuit (3), le corps de base de boîtier (2) est comprimé dans une direction transversale à l'extension de la surface du support de circuit (3).
